# EUROPEAN PATENT APPLICATION

(11) **EP 4 517 356 A1**
(43) Date of publication of application: **05.03.2025**
(21) Application number: 23193646.9
(22) Date of filing: 28.08.2023
(51) Int. Cl.: G01R 33/36

(54) **DIGITAL MAGNETIC RESONANCE IMAGING COIL INTERFACE**

(71) Applicant: Koninklijke Philips N.V., 5656 AG Eindhoven (NL)
(72) Inventor: LIPS, Oliver, Eindhoven (NL); JOHNSON, Mark Thomas, Eindhoven (NL); VOGTMEIER, Gereon, 5656AG Eindhoven (NL); Steffen, WEISS, Eindhoven (NL); LEUSSLER, Christoph Günther, Eindhoven (NL); KOEHLER, Thomas, Eindhoven (NL)
(74) Representative: Philips Intellectual Property & Standards

(57) **Abstract**

Disclosed herein is a medical system (100, 300, 400, 500, 600, 700) comprising a digital magnetic resonance imaging coil interface (102). The execution of local machine executable instructions (120) causes a local computational system (116) to repeatedly: receive (200) an analog detune control signal using a detune control port (110); generate (202) the digital detune control signal by digitizing the received analog detune control signal with an analog-to-digital converter (112); and transmit (204) the digital detune control signal using the local digital transceiver; control (206) a local digital transceiver (104) to receive a digital magnetic resonance imaging signal (122) from a digital magnetic resonance imaging coil (402); generate (208) the reconstructed analog magnetic resonance imaging signal from the received digital magnetic resonance imaging signal using the digital-to-analog converter; and render (210) the reconstructed analog magnetic resonance imaging signal to a radio-frequency port (106, 106").

## Description

### FIELD OF THE INVENTION

The invention relates to magnetic resonance imaging, in particular to the use of digital magnetic resonance imaging coils.

### BACKGROUND OF THE INVENTION

Large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially by manipulating atomic spins using MRI by manipulating magnetic field gradients and radio-frequency (RF) pulses transmitted using a magnetic resonance imaging (transmit) coil or antenna. The manipulation of the spins results in RF transmissions or echoes which are received either by the same magnetic resonance imaging coil or a specialized receive coil and digitized. The digitized (sampled) echoes are k-space data. The k-space data can be Fourier transformed into a magnetic resonance image. When measuring (sampling) the k-space data there are huge advantages to having the sampling electronic as close as possible to the actual antenna element. It eliminates impedance matching and transmission problem between the antenna and a RF receiver.

United State patent application publication US 2018/008109 A1 discloses a transmission apparatus for legacy magnetic resonance (MR) systems including one or more of a radio transmission portion having coupling to an analog RF cable port of the MR system including at least one first controller, an analog-to-digital converter (A/D), and a transmitter. The first controller controls the A/D to digitize analog magnetic resonance (MR) information received from the RF coil and controls the transmitter to transmit the digitized MR information. A radio reception portion including an analog output port and a coupler for coupling the output port to a legacy cable port input of the legacy system including at least one second controller, a receiver, and a digital-to-analog converter (D/A). The second controller controls the receiver to receive the transmitted digitized MR information and controls the D/A to perform a digital-to-analog conversion to form a corresponding analog MR signal which is output at the output port.

### SUMMARY OF THE INVENTION

The invention provides for a medical system, a method, and a computer program in the independent claims. Embodiments are given in the dependent claims.

In one aspect the invention provides for a medical system that comprises a digital magnetic resonance imaging coil interface. The digital magnetic resonance imaging coil interface comprises a local digital transceiver that is configured to receive a digital magnetic resonance imaging signal from a digital magnetic resonance imaging coil and to transmit a digital detune control signal to the digital magnetic resonance imaging coil. The magnetic resonance imaging coil further comprises a radio-frequency port. The radio-frequency port may be a connector or radio-frequency connector that provides access to a receiver or transceiver of a radio-frequency system of a magnetic resonance imaging system. The digital magnetic resonance imaging coil interface further comprises a digital-to-analogue converter that is configured for outputting a reconstructed analogue magnetic resonance imaging signal to the radio-frequency port. The digital magnetic resonance imaging coil interface further comprises a detune control port that is configured to receive an analogue coil detune control signal.

The digital magnetic resonance imaging coil interface further comprises an analogue-to-digital converter that is configured to digitize the analogue coil detune control signal. That is to say, the detune control port receives the analogue coil detune control signal and then is digitized by the analogue-to-digital converter. The digital magnetic resonance imaging coil interface further comprises a local memory storing local machine-executable instructions. The digital magnetic resonance imaging coil interface further comprises a local computational system.

Execution of the local machine-executable instructions causes the local computational system to repeatedly receive the analogue detune control signal using the detune control port. Execution of the local machine-executable instructions further causes the local computational system to repeatedly generate the digital detune control signal by digitizing the received analogue detune control signal with the analogue-to-digital converter. Execution of the local machine-executable instructions further causes the local computational system to repeatedly transmit the digital detune control signal using the local digital transceiver.

Execution of the local machine-executable instructions further causes the local computational system to repeatedly control the local digital transceiver to receive the digital magnetic resonance imaging signal. Execution of the local machine-executable instructions further causes the local computational system to repeatedly generate the reconstructed analogue magnetic resonance imaging signal from the received digital magnetic resonance imaging signal using the digital-to-analogue converter. Execution of the local machine-executable instructions further causes the local computational system to repeatedly render the reconstructed analogue magnetic resonance imaging signal to the radio-frequency port.

In another aspect, the invention provides for a method of operating a medical system. The medical system comprises a digital magnetic resonance imaging coil interface. The digital magnetic resonance imaging coil interface comprises a local digital transceiver that is configured to receive a digital magnetic resonance imaging signal from a digital magnetic resonance imaging coil and to transmit a digital detune control signal to the digital magnetic resonance imaging coil. The digital magnetic resonance imaging coil interface further comprises a radio-frequency port. The digital magnetic resonance imaging coil interface further comprises a digital-to-analogue converter that is configured for outputting a reconstructed analogue magnetic resonance imaging signal to the radio-frequency port. The digital magnetic resonance imaging coil interface further comprises a detune control port that is configured to receive an analogue coil detune control signal. The digital magnetic resonance imaging coil interface further comprises an analogue-to-digital converter that is configured to digitize the analogue coil detune control signal.

The method comprises repeatedly receiving the analogue detune control signal using the detune control port. The method further comprises repeatedly generating the digital detune control signal by digitizing the received analogue detune control signal with the analogue-to-digital converter. The method further comprises repeatedly transmitting the digital detune control signal using the local digital transceiver. The method further comprises repeatedly controlling the local digital transceiver to receive the digital magnetic resonance imaging signal. The method further comprises repeatedly generating the reconstructed analogue magnetic resonance imaging signal from the received digital magnetic resonance imaging signal using the digital-to-analogue converter. The method further comprises repeatedly rendering the reconstructed analogue magnetic resonance imaging signal to the radio-frequency port.

In another aspect the invention provides for a computer program that comprises local machine-executable instructions for execution by a local computational system that controls a digital magnetic resonance imaging coil interface. The digital magnetic resonance imaging coil interface comprises a local digital transceiver that is configured to receive a digital magnetic resonance imaging signal from a digital magnetic resonance imaging coil and to transmit a digital detune control signal to the digital magnetic resonance imaging coil. The digital magnetic resonance imaging coil interface further comprises a radio-frequency port.

The digital magnetic resonance imaging coil interface further comprises a digital-to-analogue converter configured for outputting a reconstructed magnetic resonance imaging signal to the radio-frequency port. The digital magnetic resonance imaging coil interface further comprises a detune control port that is configured to receive an analogue coil detune control signal. The digital magnetic resonance imaging coil interface further comprises an analogue-to-digital converter that is configured to digitize the analogue detune control signal.

Execution of the local machine-executable instructions causes the local computational system to repeatedly receive the analogue detune control signal using the detune control port. Execution of the local machine-executable instructions further causes the local computational system to repeatedly generate the digital detune control signal by digitizing the received analogue detune control signal with the analogue-to-digital converter. Execution of the local machine-executable instructions further causes the local computational system to repeatedly transmit the digital detune control signal using the local digital transceiver.

Execution of the local machine-executable instructions further causes the local computational system to repeatedly control the local digital transceiver to receive the digital magnetic resonance imaging signal. Execution of the local machine-executable instructions further causes the local computational system to repeatedly generate the reconstructed analogue magnetic resonance imaging signal from the received digital magnetic resonance imaging signal using the digital-to-analogue converter. Execution of the local machine-executable instructions further causes the local computational system to repeatedly render the reconstructed analogue magnetic resonance imaging signal to the radio-frequency port.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 illustrates a further example of a medical system;
Fig. 4 illustrates a further example of a medical system;
Fig. 5 illustrates a further example of a medical system;
Fig. 6 illustrates a further example of a medical system;
Fig. 7 illustrates a further example of a medical system;
Fig. 8 shows a flow chart which illustrates a method of using the medical system of Fig. 7; and
Fig. 9 illustrates the antenna latency value.

### DETAILED DESCRIPTION OF EMBODIMENTS

Like numbered elements in these figures are either equivalent elements or perform the same function. Elements which have been discussed previously will not necessarily be discussed in later figures if the function is equivalent.

Examples may be beneficial because they may provide a means of using a digital magnetic resonance imaging coil with a magnetic resonance imaging system that is not configured to operate with digital magnetic resonance imaging coils but instead conventional analogue magnetic resonance imaging coils. It may be difficult to update a legacy magnetic resonance imaging system because the software used to control the magnetic resonance imaging system may be old or the source code may not even be available. The digital magnetic resonance imaging coil interface may provide a means of adding additional functionality to a legacy magnetic resonance imaging system.

The generation of the reconstructed analogue magnetic resonance imaging signal and its rendering may be accomplished in different examples in different implementations. For example, the received digital magnetic resonance imaging signal may for example have been down-converted to a lower frequency as is typical in radio communications, in which case the generation and the rendering may involve up-conversion of the signal using either digital techniques and/or analogue radio-frequency components.

Analogue magnetic resonance imaging coils typically contain a detune circuit which enables the antenna or coil element to be detuned selectively. For example, if the magnetic resonance imaging coil is a receive coil it is not advantageous to have the receive coil tuned to the same frequency as the transmit coil when the transmit coil is operating. To achieve this in a magnetic resonance imaging system there is typically a detune control signal which is controlled as part of the pulse sequence so that the receive coils can effectively be removed from the frequency range during transmission.

The local memory is a memory and the identifier 'local' is to refer to a specific or particular memory. Likewise, the local machine-executable instructions are machine-executable instructions that are intended to be operated on the local computational system.
A local computational system as used herein encompasses a computational system and the term 'local' is an identifier of a particular computational system.

In another example the digital magnetic resonance imaging coil further comprises a coil identifier port connected to an identifier circuit and configured to provide a coil identifier. This example may be beneficial because it may provide for a means of configuring a magnetic resonance imaging system to work with a digital magnetic resonance imaging coil. The identifier circuit may take different forms in different examples. In one example the identifier circuit is a termination circuit that is configured to provide a predetermined impedance at the coil identifier port as a coil identifier. Often times the predetermined impedance will be used to indicate to the magnetic resonance imaging system what the impedance of the magnetic resonance imaging coil is. In some examples the coil identifier port is identical with the radio-frequency port. For example, the predetermined impedance may for example be set by an adjustable resistor bridge controlled by the local computational system.

In other examples the identifier circuit is a circuit which is used to provide a digital code via the coil identifier port. Often times older analogue coils would have an EPROM which would have a serial number or other data which can be used as a coil identifier in order to configure the magnetic resonance imaging system to use the coil properly. This can easily be emulated by the local computational system sending this digital code instead. For example, the digital magnetic resonance imaging coil interface may receive a configuration code or identifier from the digital magnetic resonance imaging coil. The local computational system could then be controlled such that it converts it to the coil identifier. This may be either the value of the predetermined impedance or it may also be the digital code.

In another example the local memory comprises calibration data. Execution of the local machine-executable instructions further causes the local computational system to scale the reconstructed analogue magnetic resonance imaging signal using the calibration data. This may be useful because it may provide the reconstructed magnetic resonance imaging signal in a format which is compatible with a magnetic resonance imaging system.

In another example the digital magnetic resonance imaging coil interface further comprises multiple radio-frequency ports. The radio-frequency ports comprise the radio-frequency port. The digital magnetic resonance imaging coil interface is configured to function as a multiplexer to provide multiple reconstructed analogue magnetic resonance imaging signals using the multiple radio-frequency ports. For example, the digital magnetic resonance imaging signal may actually be data for more than one antenna or coil element. Often times receive coils will have multiple receive elements. This may be easily sent in the digital magnetic resonance imaging signal. In this example these multiple signals are then used to generate multiple output signals on the multiple radio-frequency ports. This may be particularly useful in reducing the number of cables going from a legacy magnetic resonance imaging system to a digital magnetic resonance imaging coil. For example, the digital magnetic resonance imaging coil may have a single digital interface which goes to the digital magnetic resonance imaging coil interface which then essentially has a breakout for all of these multiple signals.

In another example execution of the local machine-executable instructions further causes the local computational system to provide the reconstructed analogue magnetic resonance imaging signal at the radio-frequency port within a predetermined delay with respect to receiving the digital magnetic resonance imaging signal at the local digital transceiver. For example, there may be a set number of clock cycles in this delay or a predetermined temporal delay. This may be beneficial because the reconstructed analogue magnetic resonance imaging signal is essentially provided in real time when the digital magnetic resonance imaging signal is received.

In another example the local digital transceiver is configured to receive the digital magnetic resonance imaging signal via a radio communication channel. For example, a Bluetooth or other low power radio-frequency communication protocol may be used to establish communication between the digital magnetic resonance imaging coil and the digital magnetic resonance imaging coil interface. This may be particularly convenient when adding a digital magnetic resonance imaging coil to a legacy magnetic resonance imaging system.

In another embodiment the local digital transceiver is configured to receive the digital magnetic resonance imaging signal via a fiber optic communication channel. This may be particularly beneficial because the fiber optic communication channel may be bidirectional and it may be used for example to transmit multiple signals from multiple magnetic resonance imaging coils.

In another example, the medical system further comprises at least one digital magnetic resonance imaging coil. The digital magnetic resonance imaging coil comprises at least one antenna element configured for receiving an original magnetic resonance imaging signal. The digital magnetic resonance imaging coil further comprises a coil detune circuit configured for detuning the at least one antenna element. As is mentioned previously, this may be beneficial particularly for receive coils so that the receive coil does not interfere with the transmission part of the pulse sequence.

The digital magnetic resonance imaging coil further comprises a coil control unit. The coil control unit comprises a radio-frequency receiver configured to receive the original magnetic resonance imaging signal from the at least one antenna element. The coil control unit is configured to convert the original magnetic resonance imaging signal into the digital magnetic resonance imaging signal. The coil control unit further comprises a coil digital transceiver that is configured for transmitting the digital magnetic resonance imaging system to the local digital transceiver. The coil digital transceiver is further configured for receiving the digital detune control signal from the local digital transceiver. The coil control unit is further configured for controlling the coil detune circuit to tune or detune the magnetic resonance imaging coil using the digital detune signal. This example may be beneficial because it provides for a digital magnetic resonance imaging coil that is integrated with a digital magnetic resonance imaging coil interface that may be used with magnetic resonance imaging systems that are configured for using analogue coils such as legacy magnetic resonance imaging systems.

In another aspect the digital magnetic resonance imaging coil further comprises a structural component. The digital magnetic resonance imaging coil interface and the digital magnetic resonance imaging coil are attached to the structural component. In this example the digital magnetic resonance imaging coil and the digital magnetic resonance imaging coil interface are connected mechanically. This means that the digital magnetic resonance imaging coil interface is included and part of the magnetic resonance imaging coil. This may be beneficial because it may have the same form as a conventional analogue magnetic resonance imaging coil. This may for example be more convenient for some users.

In another example the medical system further comprises a magnetic resonance imaging system. The magnetic resonance imaging system comprises a radio-frequency system that is configured for measuring k-space data during operation of the magnetic resonance imaging system. The radio-frequency system is connected to the radio-frequency port to receive the reconstructed analogue magnetic resonance imaging signal. The magnetic resonance imaging system further comprises a coil detune unit connected to the detune control port configured to generate the analogue coil detune control signal. The magnetic resonance imaging further comprises a main memory storing system machine-executable instructions and pulse sequence commands. The pulse sequence commands may be commands or data which may be converted into such commands which are used to control the magnetic resonance imaging system to acquire the k-space data according to a magnetic resonance imaging protocol.

The magnetic resonance imaging system further comprises a main computational system. Execution of the system machine-executable instructions causes the main computational system to control the magnetic resonance imaging system with the pulse sequence commands to acquire the k-space data. Controlling the magnetic resonance imaging system with the pulse sequence commands comprises controlling the radio-frequency system to acquire the k-space data by sampling the reconstructed analogue magnetic resonance imaging signal and controlling the coil detuning to control detuning of the at least one antenna element via the analogue coil detune control signal. The control of the coil detune unit may for example be specified in the pulse sequence commands. The controlling of the detuning may occur before the k-space data is sampled.

This example may be beneficial because it provides for the integration of a digital magnetic resonance imaging coil into a magnetic resonance imaging system which is not configured to receive the digital magnetic resonance imaging coil signal.

In another aspect the coil detune circuit is configured to generate a detune status signal. The detune status signal may for example be a signal which is used to indicate that the coil is indeed detuned. It may for example be provided as a feedback signal that is complimentary to the analogue detune control signal.

The coil control unit is configured to receive the detune status signal. The coil control unit is configured to generate a digital detune feedback signal from the received detune status signal. The coil control unit is configured to transmit the digital detune feedback signal to the local digital transceiver using the coil digital transceiver. The digital magnetic resonance imaging coil interface further comprises a detune feedback port that is configured to output an analogue detune feedback signal. The detune feedback signal is used to indicate that the digital magnetic resonance imaging coil has been successfully detuned. This may typically be indicated using a specified voltage or current.
The detuning of the receive coil may be considered a safety feature, thus its proper function is typically monitored. This is usually done by monitoring the detune feedback signal.

Execution of the local machine-executable instructions further causes the local computational system to repeatedly receive the digital detune feedback signal using the local digital transceiver. Execution of the local machine-executable instructions further causes the local computational system to repeatedly generate the analogue detune feedback signal from the received digital detune feedback signal. Execution of the local machine-executable instructions further causes the local computational system to repeatedly render the analogue detune feedback signal at the detune feedback port using the digital-to-analogue converter.

Execution of the system machine-executable instructions further causes the computational system to adjust execution of the pulse sequence commands using the analogue detune feedback signal. For example, the analogue detune feedback signal may be used to ensure that no transmissions are made until the coil detune circuit has indeed detuned the magnetic resonance imaging coil.

In another example, execution of the machine-executable instructions further causes the main computational system to reconstruct a magnetic resonance image from the k-space data. This embodiment may be beneficial because the k-space data has been acquired using a digital magnetic resonance imaging coil instead of an analogue one. There may for example be less signal-to-noise or other problems with the k-space data. The reconstructed magnetic resonance image may therefore have superior quality.

In another aspect the system memory further stores an antenna latency value. The antenna latency value is descriptive of a delay between providing the reconstructed analogue magnetic resonance imaging signal at the radio-frequency port and receiving of the original magnetic resonance imaging signal by the radio-frequency receiver. Execution of the system machine-executable instructions further cases the main computational system to adjust pulse sequence commands to compensate for the antenna latency value. In examples the analogue signal received by the magnetic resonance imaging antenna is digitized and then re-converted into an analogue signal. This is the source of this antenna latency value. By introducing delays this latency can be compensated for and the performance is not limited by the antenna latency value.

In some examples the digital magnetic resonance imaging coil interface may communicate the antenna latency value to the magnetic resonance imaging system via a digital communication system. In other examples this may be set manually.

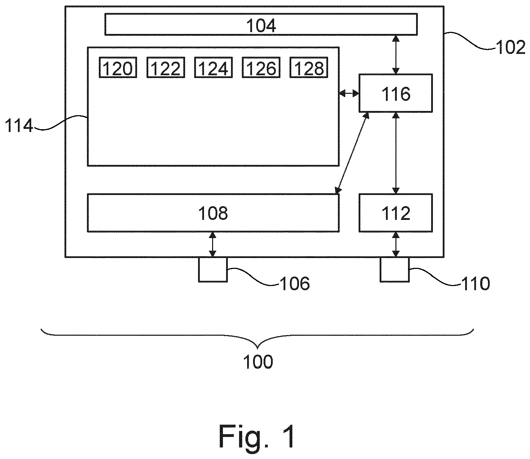

Fig. 1 illustrates an example of a medical system 100. The medical system 100 comprises a digital magnetic resonance imaging coil interface 102. The digital magnetic resonance imaging coil interface comprises a local digital transceiver 104. Depending upon different examples the local digital transceiver 104 may take different forms. In some examples it may be a digital radio communication system, a fiber optic transceiver, or it may simply be a wired transceiver.

The digital magnetic resonance imaging coil interface 102 is further shown as comprising a radio-frequency port 106. The radio-frequency port 106 is connected to a digital-to-analogue converter 108. The digital magnetic resonance imaging coil interface 102 is shown as further comprising a detune control port 110. The detune control port 110 is configured to receive an analogue signal. The digital magnetic resonance imaging coil interface 102 is shown as comprising an analogue-to-digital converter 112. The digital magnetic resonance imaging coil interface 102 is further shown as comprising a local memory 114 and a local computational system 116. The local digital transceiver 104, the digital-to-analogue converter 108, the analogue-to-digital converter 112, and the local memory 114 are shown as being in communication with the local computational system 116.

The local memory 114 is shown as storing local machine-executable instructions 120. The local machine-executable instructions 120 enables the local computational system 116 to control the various components of the digital magnetic resonance imaging coil interface 102 as well as perform various data transformation and calculations. The memory 114 is further shown as containing a digital magnetic resonance imaging signal 122 that was received via the local digital transceiver 104. The memory 114 is further shown as containing a reconstructed analogue magnetic resonance imaging signal 124. The reconstructed analogue magnetic resonance imaging signal 124 may be rendered using the radio-frequency port 106 and the digital-to-analogue converter 108. The memory 114 is further shown as containing a digitized analogue control signal 126 that was received as an analogue control signal at the detune control port 110 and digitized using the analogue-to-digital converter 112. The various components of the digital magnetic resonance imaging coil interface 102 are functional blocks. The various components may be integrated together or may be implemented discreetly.

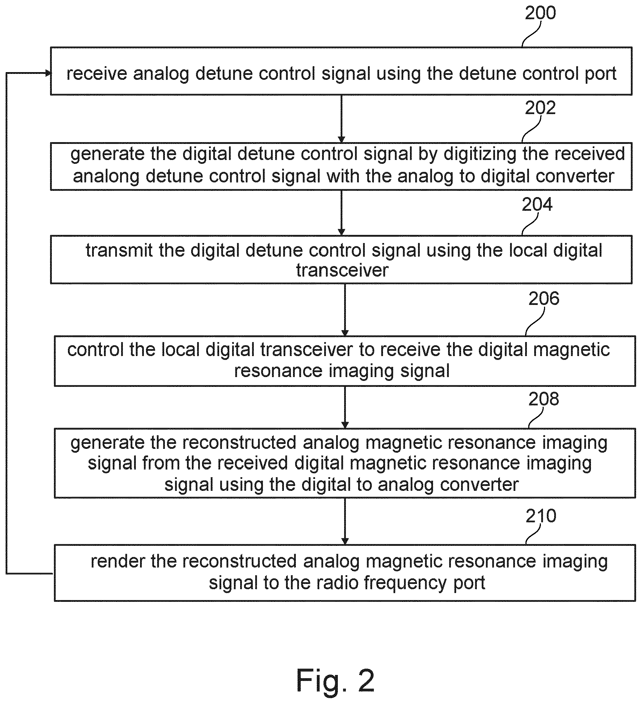

Fig. 2 shows a flowchart which illustrates a method of operating the medical system 100 of Fig. 1. In step 200 the reconstructed analogue magnetic resonance imaging signal 124 is rendered at the radio-frequency port 106. In block 202 the analogue detune control signal is received using the detune control port 110. In step 204 the digital detune control signal 128 is generated by digitizing the received analogue detune control signal with the analogue-to-digital converter 112. This creates the digitized analogue control signal 126 which is then in turn used to generate the digital detune control signal 128. In block 210 the digital detune control signal 128 is transmitted using the local digital transceiver 104. In step 206 the local digital transceiver 104 is controlled to receive the digital magnetic resonance imaging signal 122. In block 208 the reconstructed analogue magnetic resonance imaging signal 124 is generated from the received digital magnetic resonance imaging signal 122 using the digital-to-analogue converter 108. In some cases, there may also be additional analogue components such as an up-converter. In step 210 the reconstructed analogue magnetic resonance imaging signal 124 is rendered at the radio-frequency port 106. After block 210 is performed the block returns to step 200.

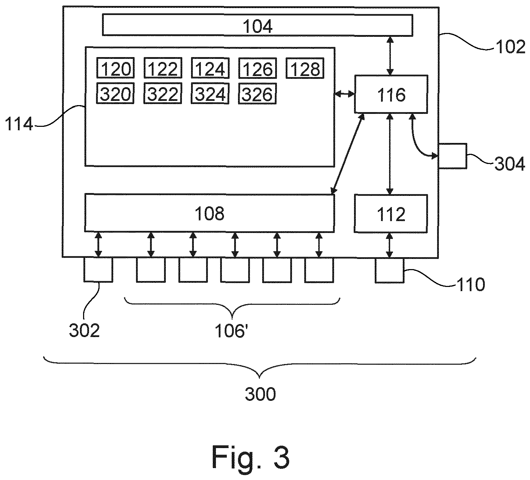

Fig. 3 illustrates a further example of a medical system 300. The medical system 300 comprises a digital magnetic resonance imaging coil interface 102 that is similar to the digital magnetic resonance imaging coil interface 102 illustrated in Fig. 1. Instead of having a single radio-frequency port 106 connected to the digital-to-analogue converter 108 there are multiple radio-frequency ports 106' connected to the digital-to-analogue converter 108. In this example the digital magnetic resonance imaging signal 122 may comprise the signal from multiple magnetic resonance imaging coils or antennas. The multiple radio-frequency ports 106' function as a multiplexer.

The digital magnetic resonance imaging coil interface 102 is further shown as comprising a detune feedback port 302. The detune feedback port 302 is configured to output an analogue detune feedback signal. The digital magnetic resonance imaging coil interface 102 is further shown as comprising a coil identifier port 304. In this example the coil identifier port 304 is a digital output where the local computational system 116 functions as an identifier circuit to provide a coil identifier 320. The coil identifier 320 is shown as being stored in the local memory 114. The coil identifier 320 could for example be received via the local digital transceiver 104. In other examples the coil identifier port 304 would instead provide an impedance which is recognized by the magnetic resonance imaging system as a means of providing information about the impedance of the magnetic resonance imaging coil. The local computational system 116 could for example be used to control a variable resistor to set this impedance at the coil identifier port 304.

The memory is further shown as comprising calibration data 322. The calibration data 322 may for example also be received via the local digital transceiver 104. The calibration data 322 is used to scale or modify the output or amplitude of the reconstructed analogue magnetic resonance imaging signal 124. This may depend upon the particular digital magnetic resonance imaging coil as well as the particular magnetic resonance imaging system.

The memory is shown as further comprising a digital detune feedback signal 324 that was received via the local digital transceiver 104. The memory 114 is further shown as containing a rendering of an analogue detune feedback signal 326 that may be rendered using the digital-to-analogue converter 108 at the detune feedback port 302.

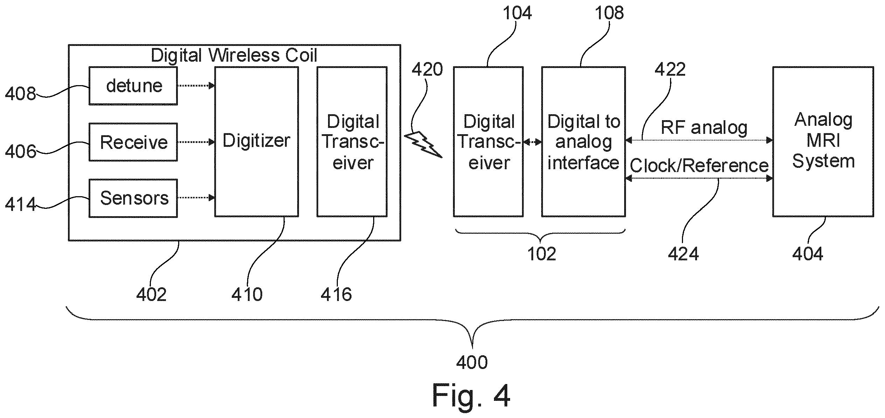

Fig. 4 illustrates a further example of the medical system 400. The medical system 400 comprises a digital magnetic resonance imaging coil 402, the digital magnetic resonance imaging coil interface 102 as illustrated in either Fig. 1 or Fig. 3 and a magnetic resonance imaging system 404. The digital magnetic resonance imaging coil 402 comprises an at least one antenna element 406 which includes coil detune circuits 408. There is a coil control unit 410 that functions as a digitizer and uses a digital transceiver 416 to transmit the digital magnetic resonance imaging signal 420 to the local digital transceiver 104 of the digital magnetic resonance imaging coil interface 102. In the example illustrated in Fig. 4 the digital magnetic resonance imaging signal 420 is transmitted using a radio signal. The digital magnetic resonance imaging coil 402 may also comprise additional sensor circuits 414. These may for example measure such things as temperature or the detune status of the at least one antenna element 406. The digital magnetic resonance imaging coil interface 102 is shown as providing a reconstructed magnetic resonance imaging signal 422 and optionally an additional signal 424 to the magnetic resonance imaging system 404. The additional signal 424 may for example be an analogue detune control signal that is received, a clock signal, a coil identifier signal which is output, and/or a detune feedback signal which is also output.

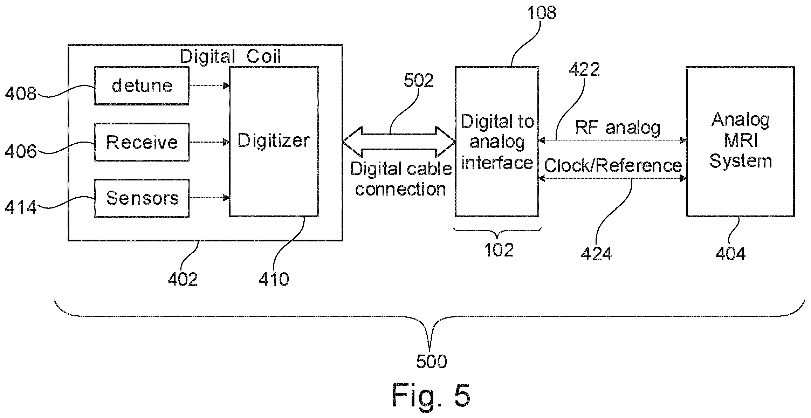

Fig. 5 illustrates a further example of a medical system 500. The medical system 500 is similar to the medical system 400 except the radio transmission 420 has been replaced with a fiber optic connection 502. The digital magnetic resonance imaging coil 402 may be conveniently placed within the magnet of the magnetic resonance imaging system 404 and connected to the digital magnetic resonance imaging coil interface 102 using the fiber optic connection 502.

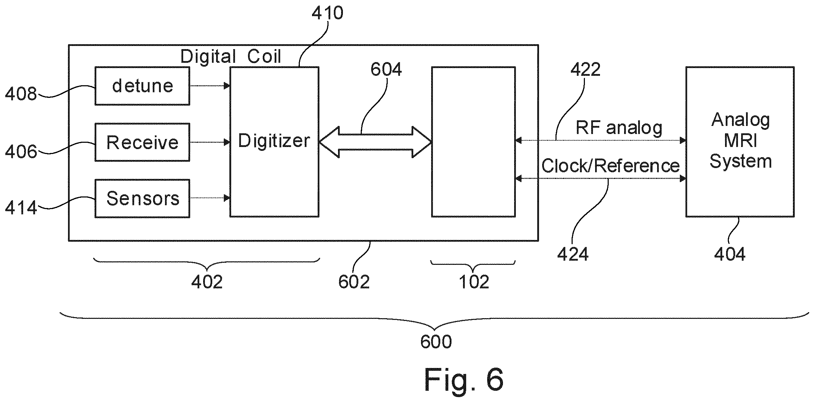

Fig. 6 illustrates a further example of the medical system 600. The medical system 600 is similar to the medical systems 400 in Fig. 4 and medical system 500 in Fig. 5 except in this case the digital magnetic resonance imaging coil 402 and the digital magnetic resonance imaging coil interface 102 are connected using a common structural component 602. For example, they may be enclosed within the same housing. In this case the combined digital magnetic resonance imaging coil 402 and digital magnetic resonance imaging interface 102 function transparently as a conventional analogue magnetic resonance imaging coil. The connections with the magnetic resonance imaging system 404 may be transparently identical to a legacy magnetic resonance imaging coil. This may for example have advantages in that the same work order or best practices for placing and positioning the coil may still be used.

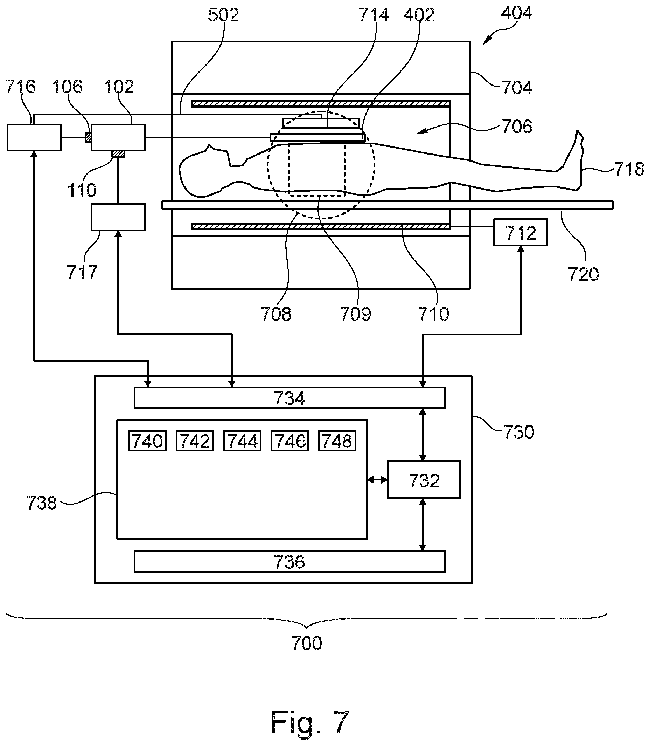

Fig. 7 illustrates a further example of the medical system 700. The medical system 700 illustrated in Fig. 7 is very similar to the medical system 500 illustrated in Fig. 5 in that a fiber optic connection 502 is used. The magnetic resonance imaging system 404 comprises a magnet 704. The magnet 704 is a superconducting cylindrical type of magnet with a bore 706 through it. The use of different types of magnets is also possible; for instance, it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 706 of the cylindrical magnet 704 there is an imaging zone 708 where the magnetic field is strong and uniform enough to perform magnetic resonance imaging. A field of view 709 is shown within the imaging zone 708. The magnetic resonance data that is typically acquired for the field of view 709. A subject 718 is shown as being supported by a subject support 720 such that at least a portion of the subject 718 is within the imaging zone 708 and the predetermined region of interest 709.

Within the bore 706 of the magnet there is also a set of magnetic field gradient coils 710 which is used for acquisition of preliminary magnetic resonance data to spatially encode magnetic spins within the imaging zone 708 of the magnet 704. The magnetic field gradient coils 710 connected to a magnetic field gradient coil power supply 712. The magnetic field gradient coils 710 are intended to be representative. Typically, magnetic field gradient coils 710 contain three separate sets of coils for spatially encoding in three orthogonal spatial directions. A magnetic field gradient power supply supplies current to the magnetic field gradient coils. The current supplied to the magnetic field gradient coils 710 is controlled as a function of time and may be ramped or pulsed.

Adjacent to the imaging zone 108 is a radio-frequency coil 714 for manipulating the orientations of magnetic spins within the imaging zone 108. The radio-frequency coil may for example be a whole body transmit coil. The digital magnetic resonance imaging coil 402 is shown as being adjacent to the subject 718 and is configured for receiving radio transmissions from spins also within the imaging zone 708.

The digital magnetic resonance imaging antenna 402 may contain multiple coil elements. The radio-frequency antenna may also be referred to as a channel or antenna. The radio-frequency coil 714 is connected to a radio-frequency transceiver (radio-frequency system 716).

The radio-frequency system 716 which comprises a transmitter connected to a transmit radio-frequency coil 714. Below the radio-frequency coil 714 is the digital magnetic resonance imaging coil 402. In this example the digital magnetic resonance imaging coil 402 is functioning as a receive coil and is placed on the subject 718. The transceiver 716 has a receiver portion which is connected to the radio-frequency port 106 of the digital magnetic resonance imaging coil interface 102. Additionally, there is a coil control unit 717 which is used to generate an analogue detune control signal. The analogue detune control signal is shown as being connected to the detune control port 110 of the digital magnetic resonance imaging coil interface 102.

The medical system 700 is further shown as comprising a computer 730. The computer 730 is intended to represent one or more computing or computational devices located at one or more locations. The computer 730 is shown as containing a main computational system 732. The main computational system 732 is intended to represent one or more computational systems that could for example be one or more processing cores located at one or more locations. Various combinations of computational systems 732 and/or computers 730 could be connected and work together cooperatively using a network. The main computational system 732 is shown as being in communication with a hardware interface 734, a user interface 736, and a main memory 738. The hardware interface 734 is an interface which enables the computational system 732 to communicate with and/or control other components of the medical system 700 such as the magnetic resonance imaging system 702. The transceiver, the coil control unit 717, and the magnetic field gradient coil power supply 712 are shown as being connected to a hardware interface 734.

The user interface 736 is a user interface that enables an operator of the medical system 700 to control and operate the medical system 700. The memory 738 is intended to represent various types of memory which may be in communication with the computational system 732.

The main memory 738 is shown as containing system machine-executable instructions 740. The system machine-executable instructions 740 contain instructions which enable the main computational system 732 to control the other components of the medical system such as the magnetic resonance imaging 404 as well as to perform various numerical and image processing tasks. The main memory 738 is further shown as containing pulse sequence commands 742 which may be used to control the magnetic resonance imaging system 404 to acquire k-space data 746, which is also shown as being stored in the memory 738. The digitization of the original magnetic resonance imaging signal transmission via the fiber optic connection 502 and then subsequent reconstruction and rendering at the radio-frequency port 106 as the reconstructed analogue magnetic resonance imaging signal takes time. The main memory 738 is further shown as storing an antenna latency value 744 which may be used to modify the pulse sequence commands 742 to account for the delay in the reception of the reconstructed analogue magnetic resonance imaging signal. The main memory 738 is further shown as containing a magnetic resonance image 748 that was reconstructed from the k-space data 746.

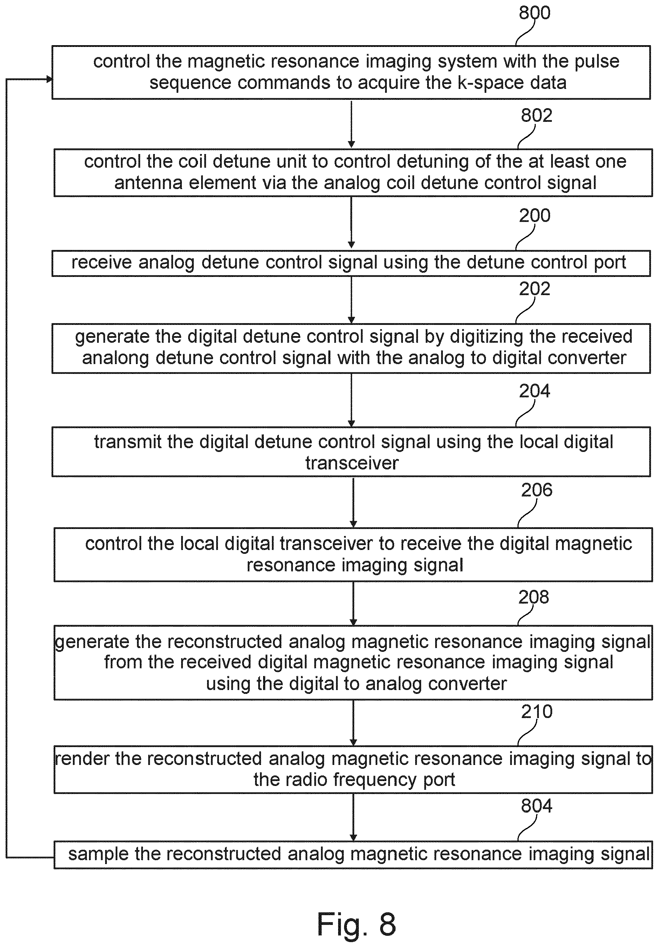

Fig. 8 shows a flowchart which illustrates a method of operating the magnetic resonance imaging system 700 of Fig. 7. In step 800 the magnetic resonance imaging system 404 is controlled with the pulse sequence commands 742 to acquire the k-space data 746. In step 804 the coil detune unit 717 is controlled in order to control the detuning of the at least one antenna element of the digital magnetic resonance imaging antenna 402 via the analogue detune control signal which is provided to the detune control port 110. Steps 200, 202, 204. 206, 208, and 210 are performed as was illustrated in Fig. 2. In step 804 the reconstructed magnetic resonance imaging signal is sampled. This sampling process produces the k-space data 746.

In some examples, the coil detune circuit may be configured to generate a detune status signal. The coil control unit could then receive the detune status signal and generate a digital detune feedback signal that is transmitted to the digital magnetic resonance imaging coil interface. The digital magnetic resonance imaging coil interface may in turn have a detune feedback port which is used to render the digital detune feedback signal as an analog detune feedback signal. The coil detune unit may be configured to receive the analog detune feedback signal. The system machine executable instructions may be configured such that the execution of the pulse sequence commands are adjusted using the analog detune feedback signal such that the at least one antenna element is properly tuned or detuned at the correct times during execution of the pulse sequence commands.

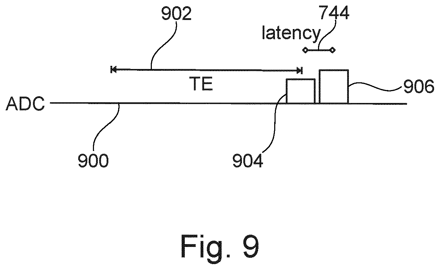

Fig. 9 illustrates the antenna latency value 744. The line 900 illustrates when the analogue-to-digital converter of the magnetic resonance imaging system 404 is active. The sampling occurs at the end of the echo time 902. This is when it is expected to be able to sample the k-space data. However, due to the digitization, transmission, and reconstruction of the constructed analogue magnetic resonance imaging signal there is a delay when the magnetic resonance imaging signal (echo) occurs. This is illustrated by the block 906. In order to properly sample the k-space data the pulse sequence commands 742 need to be modified such that the sampling occurs at a delay equal to the antenna latency value 744.

As was previously mentioned the reconversion of the original magnetic resonance imaging signal into the analog domain will take time. This latency (antenna latency value 744) may be taken into account for in the sequence programming of the MR scanner. The signal for starting the acquisition is preferably sent the corresponding amount of time later, leaving all the other sequence parameters unchanged.

This delay may be implemented in the control SW of the scanner or in adjustments to the pulse sequence. The acquisition is delayed to account for this latency, however other sequence parameter calculations may be carried out with the "correct/intended" timing. In practice the antenna latency value 744 can be measured by transmitting a known reference signal (e.g., by a pickup coil) and simultaneously measuring with the "final" analog receiver (i.e., including the DA conversion). Since the reference signal is known (e.g., a certain amplitude modulation or a frequency sweep), the delay between transmitted signal and the actually received one can be determined.

This functionality also ensures quality control of the "mix-mode" system (maybe check will be repeated from time to time to measure also drift effects (temperature) and to select the best parameters.

Potentially the adjustment of the latency is done iteratively, repeating the process after setting a latency correction based on the previous measurement. For the more accurate final settings a frequency sweep may be used. The phase of the measured signal is in this case linearly rising and its slope is indicative of the time difference between the transmitter and the receiver. This allows for a very sensitive time alignment. The final alignment does not only include the delay caused by the DA conversion, but also aligns the clocks used in the digital coil/the interface and the MR system.

The operation of the magnetic resonance imaging system or at least modifications to the pulse sequence commands may be done with a detune delay, which describe how long the coil may be set to tuned or detuned state. These delays may be taken into account by the scanner control software in order to change the states early enough or to exclude sequence timings, which cannot be realized by the coils. In combination with the proposed interface the digital coils will probably behave slightly differently, so these parameters may be measured. Since these delays are fixed for each type of coil connected to the interface they need only be determined once (e.g., during development) and can be stored on the scanner host. The measurement can e.g., be performed by doing MR measurements and reducing the delay times until changes in the image/recorded signals can be observed.

It is understood that one or more of the aforementioned examples or embodiments of the invention may be combined as long as the combined examples or embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: digital magnetic resonance imaging coil interface
- 104: local digital transceiver
- 106: radio-frequency port
- 106': multiple radio-frequency ports
- 108: digital-to-analog converter
- 110: detune control port
- 112: analog-to-digital converter
- 114: local memory
- 116: local computational system
- 120: local machine executable instructions
- 122: digital magnetic resonance imaging signal
- 124: reconstructed analog magnetic resonance imaging signal
- 126: digitized analog control signal
- 128: digital detune control signal
- 200: receive the analog detune control signal using the detune control port
- 202: generate the digital detune control signal by digitizing the received analog detune control signal with the analog-to-digital converter
- 204: transmit the digital detune control signal using the local digital transceiver
- 206: control the local digital transceiver to receive the digital magnetic resonance imaging signal
- 208: generate the reconstructed analog magnetic resonance imaging signal from the received digital magnetic resonance imaging signal using the digital-to-analog converter
- 210: render the reconstructed analog magnetic resonance imaging signal to the radio-frequency port
- 300: medical system
- 302: detune feedback port
- 304: coil identifier port
- 320: coil identifier
- 322: calibration data
- 324: digital detune feedback signal
- 326: rendering of analog detune feedback signal
- 400: medical system
- 402: digital magnetic resonance imaging coil
- 404: magnetic resonance imaging system
- 406: antenna element
- 408: coil detune circuit
- 410: coil control unit
- 414: sensor circuit
- 416: coil digital transceiver
- 420: digital magnetic resonance imaging signal
- 422: reconstructed magnetic resonance imaging signal
- 424: additional signal
- 500: medical system
- 502: fiber optic connection
- 600: medical system
- 602: common structural component
- 604: wired connection
- 700: medical system
- 704: magnet
- 706: bore of magnet
- 708: imaging zone
- 709: field of view
- 710: magnetic field gradient coils
- 712: magnetic field gradient coil power supply
- 714: radio-frequency coil (transmit)
- 716: radio-frequency system
- 717: coil detune unit
- 718: subject
- 720: subject support
- 730: computer
- 732: main computational system
- 734: hardware interface
- 736: user interface
- 738: main memory
- 740: system machine executable instructions
- 742: pulse sequence commands
- 744: antenna latency value
- 746: k-space data
- 748: magnetic resonance image
- 800: control the magnetic resonance imaging system with the pulse sequence commands to acquire the k-space data
- 802: controlling the coil detune unit to control detuning of the at least one antenna element via the analog coil detune control signal
- 804: sample the reconstructed analog magnetic resonance imaging signal
- 900: time when analog-to-digital converter samples k-space data
- 902: TE (echo time)
- 904: time when analog MRI system samples k-space data
- 906: time when k-space data should be sampled accounting for the antenna latency value

## Claims

1. A medical system (100, 300, 400, 500, 600, 700) comprising a digital magnetic resonance imaging coil interface (102), wherein the digital magnetic resonance imaging coil interface comprises:
- a local digital transceiver (104) configured to receive a digital magnetic resonance imaging signal (122) from a digital magnetic resonance imaging coil (402) and to transmit a digital detune control signal to the digital magnetic resonance imaging coil;
- a radio-frequency port (106, 106');
- a digital-to-analog converter (122) configured for outputting a reconstructed analog magnetic resonance imaging signal (124) to the radio-frequency port;
- a detune control port (110) configured to receive an analog coil detune control signal;
- an analog-to-digital converter (112) configured to digitize the analog coil detune control signal;
- a local memory (114) storing local machine executable instructions (120);
- a local computational system (116), wherein execution of the local machine executable instructions causes the local computational system to repeatedly:
- receive (200) the analog detune control signal using the detune control port;
- generate (202) the digital detune control signal by digitizing the received analog detune control signal with the analog-to-digital converter;
- transmit (24) the digital detune control signal using the local digital transceiver;
and
- control (206) the local digital transceiver to receive the digital magnetic resonance imaging signal;
- generate (208) the reconstructed analog magnetic resonance imaging signal from the received digital magnetic resonance imaging signal using the digital-to-analog converter; and
- render (210) the reconstructed analog magnetic resonance imaging signal to the radio-frequency port.

2. The medical system of claim 1, wherein the digital magnetic resonance imaging coil interface further comprises a coil identifier port (304) connected to an identifier circuit configured to provide a coil identifier (320).

3. The medical system of claim 1 or 2, wherein the local memory comprises calibration data (322), wherein execution of the local machine executable instructions further causes the local computational system to scale the reconstructed analog magnetic resonance imaging signal using the calibration data.

4. The medical system of claim 1, 2, or 3, wherein the digital magnetic resonance imaging coil interface further comprises multiple radio-frequency ports (106'), wherein the radio-frequency ports comprise the radio-frequency port, and wherein the digital magnetic resonance imaging coil interface is configured to function as a multiplexer to provide multiple reconstructed analog magnetic resonance imaging signals using the multiple radio-frequency ports.

5. The medical system of any one of the preceding claims, wherein execution of the local machine executable instructions causes the local computational system to provide the reconstructed analog magnetic resonance imaging signal at the radio-frequency port with a predetermined delay with respect to the receiving of the digital magnetic resonance imaging signal at the local digital transceiver.

6. The medical system of any one of the preceding claims, wherein the local digital transceiver is configured to receive the digital magnetic resonance imaging signal via a radio communication channel (420).

7. The medical system of any one of claims 1 through 5, wherein the local digital transceiver is configured to receive the digital magnetic resonance imaging signal via a fiber optic communication channel (502).

8. The medical system of any one of the preceding claims, wherein the medical system further comprises at least one digital magnetic resonance imaging coil, wherein the digital magnetic resonance imaging coil comprises:
- at least one antenna element (406) configured for receiving an original magnetic resonance imaging signal;
- a coil detune circuit (408) configured for detuning the at least one antenna element;
- a coil control unit (410), wherein the coil control unit comprises a radio-frequency receiver configured to receive the original magnetic resonance imaging signal from the at least one antenna element, wherein the coil control unit is configured to convert the original magnetic resonance imaging signal into the digital magnetic resonance imaging signal, wherein the coil control unit further comprises a coil digital transceiver configured for transmitting the digital magnetic resonance imaging system to the local digital transceiver, wherein the coil digital transceiver is further configured for receiving the digital detune control signal from the local digital transceiver, and wherein the coil control unit is further configured for controlling the coil detune circuit to tune or detune the magnetic resonance imaging coil using the digital detune signal.

9. The medical system of claim 8, wherein the wherein the digital magnetic resonance imaging coil further comprises a structural component (602), and wherein the digital magnetic resonance imaging coil interface and the digital magnetic resonance imaging coil are attached to the structural component.

10. The medical system of claim 8 or 9, wherein the medical system further comprises a magnetic resonance imaging system (404), wherein the magnetic resonance imaging system comprises:
- a radio-frequency system (716) configured for measuring k-space data (746) during operation of the magnetic resonance imaging system, wherein the radio-frequency system is connected to the radio-frequency port to receive the reconstructed analog magnetic resonance imaging signal;
- a coil detune unit (717) connected to the detune control port configured to generate the analog coil detune control signal;
- a main memory (738) storing system machine executable instructions (740) and pulse sequence commands (742);
- a main computational system (732), wherein execution of the system machine executable instructions causes the main computational system to control (800) the magnetic resonance imaging system with the pulse sequence commands to acquire the k-space data, wherein controlling the magnetic resonance imaging system with the pulse sequence commands comprises:
- controlling (802) the coil detune unit to control detuning of the at least one antenna element via the analog coil detune control signal; and
- controlling (804) the radio-frequency system to acquire the k-space data by sampling the reconstructed analog magnetic resonance imaging signal.

11. The medical system of claim 10, wherein the coil detune circuit is configured to generate a detune status signal, wherein the coil control unit is configured to receive the detune status signal, wherein the coil control unit is configured to generate a digital detune feedback signal from the received detune status signal, wherein the coil control unit is configured to transmit the digital detune feedback signal to the local digital transceiver using the coil digital transceiver, wherein the digital magnetic resonance imaging coil interface further comprises a detune feedback port configured to output an analog detune feedback signal,
wherein execution of the local machine executable instructions further causes the local computational system to repeatedly:
- receive the digital detune feedback signal using the local digital transceiver;
- generate the analog detune feedback signal from the received digital detune feedback signal; and
- render the analog detune feedback signal at the detune feedback port using the digital-to-analog converter; and
wherein execution of the system machine executable instructions further causes the main computational system to adjust execution of the pulse sequence commands using the analog detune feedback signal.

12. The medical system of claim 11, wherein execution of the system machine executable instructions further causes the main computational system to reconstruct a magnetic resonance image (748) from the k-space data.

13. The medical system of claim 11 or 12, wherein the system memory further stores an antenna latency value (744), wherein the antenna latency value is descriptive of a delay between providing the reconstructed analog magnetic resonance imaging signal at the radio-frequency port and receiving of the original magnetic resonance imaging signal by the radio-frequency receiver, wherein execution of the system machine executable instructions further causes the main computational system to adjust the pulse sequence commands to compensate for the antenna latency value.

14. A method of operating a medical system (100, 300, 400, 500, 600, 700), wherein the medical system comprises a digital magnetic resonance imaging coil interface (102), wherein the digital magnetic resonance imaging coil interface comprises:
- a local digital transceiver (104) configured to receive a digital magnetic resonance imaging signal (122) from a digital magnetic resonance imaging coil (402) and to transmit a digital detune control signal to the digital magnetic resonance imaging coil;
- a radio-frequency port (106, 106');
- a digital-to-analog converter (112) configured for outputting a reconstructed analog magnetic resonance imaging signal to the radio-frequency port;
- a detune control port (110) configured to receive an analog coil detune control signal; and
- an analog-to-digital converter (112) configured to digitize the analog coil detune control signal;
wherein the method comprises repeatedly:
- receiving (200) the analog detune control signal using the detune control port;
- generating (202) the digital detune control signal by digitizing the received analog detune control signal with the analog-to-digital converter; and
- transmitting (204) the digital detune control signal using the local digital transceiver.
- controlling (206) the local digital transceiver to receive the digital magnetic resonance imaging signal;
- generating (208) the reconstructed analog magnetic resonance imaging signal from the received digital magnetic resonance imaging signal using the digital-to-analog converter; and
- rendering (210) the reconstructed analog magnetic resonance imaging signal to the radio-frequency port.

15. A computer program comprising local machine executable instructions (120) for execution by a local computational system (116) controlling a digital magnetic resonance imaging coil interface, wherein the digital magnetic resonance imaging coil interface comprises:
- a local digital transceiver (104) configured to receive a digital magnetic resonance imaging signal (122) from a digital magnetic resonance imaging coil (402) and to transmit a digital detune control signal to the digital magnetic resonance imaging coil;
- a radio-frequency port (106, 106');
- a digital-to-analog converter (122) configured for outputting a reconstructed analog magnetic resonance imaging signal to the radio-frequency port;
- a detune control port (110) configured to receive an analog coil detune control signal; and
- an analog-to-digital converter (112) configured to digitize the analog coil detune control signal;
wherein execution of the local machine executable instructions causes the local computational system to repeatedly:
- receive (200) the analog detune control signal using the detune control port;
- generate (202) the digital detune control signal by digitizing the received analog detune control signal with the analog-to-digital converter;
- transmit (204) the digital detune control signal using the local digital transceiver.
- control (206) the local digital transceiver to receive the digital magnetic resonance imaging signal;
- generate (208) the reconstructed analog magnetic resonance imaging signal from the received digital magnetic resonance imaging signal using the digital-to-analog converter; and
- render (210) the reconstructed analog magnetic resonance imaging signal to the radio-frequency port.
